# EUROPÄISCHE PATENTSCHRIFT

(11) **EP 3 306 311 B1**
(45) Veröffentlichungstag und Bekanntmachung des Hinweises auf die Patenterteilung: **13.04.2022**
(21) Anmeldenummer: 17183782.6
(22) Anmeldetag: 28.07.2017
(51) Int. Cl.: G01N 29/02, B06B 1/06, G01N 29/036, G01N 29/22, G01N 29/24, G01N 9/00, H01L 41/053, H01L 41/25, H03H 9/17

(54) **KRYOTAUGLICHER RESONATOR-SENSOR**
KRYO-CAPABLE RESONATOR SENSOR
CAPTEUR RÉSONATEUR CRYO

(30) Priorität: 05.10.2016 DE 102016118897
(43) Veröffentlichungstag der Anmeldung: 11.04.2018
(73) Patentinhaber: ArianeGroup GmbH, 82024 Taufkirchen (DE)
(72) Erfinder: Lindner, Gerhard, 96450 Coburg (DE); Fairuschin, Viktor, 96450 Coburg (DE); Konopka, Martin, 28199 Bremen (DE)
(74) Vertreter: Marschall, Stefan

(56) Entgegenhaltungen:
- DE-A1- 4 436 813
- DE-U1- 9 100 101
- US-A1- 2006 202 592
- US-A1- 2007 052 970
- US-A1- 2015 015 118
- US-A1- 2015 096 385

## Beschreibung

Die vorliegende Erfindung betrifft einen Resonator-Sensor zur Erfassung einer Gasdichte und/oder einer Gaszusammensetzung, einen Tank für kryogenen Treibstoff für einen Raketenantrieb sowie eine Vorrichtung und ein Verfahren zur Bestimmung einer Gasdichte und/oder einer Gaszusammensetzung. Insbesondere betrifft die vorliegende Erfindung eine Technik zur Bestimmung der Zusammensetzung einer kryogenen Treibstoff-Schutzgas-Mischung für einen Raketenantrieb.

In Tankbehältern für kryogene Treibstoffe (wie z.B. flüssigen Wasserstoff oder flüssigen Sauerstoff) befindet sich häufig ein inertes Schutzgas unter Überdruck (z.B. Helium bei 4 bar Überdruck). Im Einsatzfall wird ein Teil des Treibstoffs verdampfen, so dass sich im Gasvolumen eine binäre Gasmischung einstellt (z.B. Helium-Wasserstoff, Helium-Sauerstoff oder Helium-Stickstoff), deren Zusammensetzung im Sinne der gezielten Steuerung des Raketenantriebs und der technischen Weiterentwicklung der beteiligten Komponenten zu überwachen ist. Wenn zwei kryogene Tanks übereinander angeordnet werden und in dem einem Tank z.B. flüssiger Wasserstoff und in dem anderen Tank z.B. flüssiger Sauerstoff enthalten ist, ist die Überwachung der Gasmischung im Zwischenraum zwischen den Tanks im Sinne der Sicherheit von Interesse, um Leckagen (Wasserstoff/ Helium; Sauerstoff/ Helium) und zündfähige Gemische (Wasserstoff/ Sauerstoff) zu detektieren.

Grundsätzlich kann eine Zusammensetzung binärer Gasgemische auf verschiedene Weisen instrumentell bestimmt werden, z.B. mit Infrarot-Absorption, elektrochemischen Wasserstoff- bzw. Sauerstoffsensoren, resistiven Halbleiter-Gassensoren, mit Wärmeleitungssensoren oder mit mechanischen bzw. akustischen Messverfahren wie Messung der Schallgeschwindigkeit oder der Resonanzfrequenz mechanischer Resonatoren.

Die jeweilige Eignung der Verfahren hängt dabei insbesondere von Umgebungsbedingungen und von den betreffenden Gasen ab. So ist beispielsweise die Methode der Infrarot-Absorption im Zusammenhang mit Helium-Wasserstoff, Helium-Stickstoff bzw. Helium-Sauerstoff ungeeignet, weil diese Gase Infrarot-inaktiv sind. Auch chemische bzw. elektrochemische Gassensoren scheiden zur genannten Überwachung der Zusammensetzung von Raketentreibstoff aus, weil sie mit Stoffumwandlungen verbunden sind. Resistive Gassensoren oder Wärmeleitungssensoren schließlich sind wegen des damit verbundenen Wärmeeintrags nur beschränkt verwendbar.

Im Zusammenhang mit der Raketenantriebstechnik kommen daher in erster Linie mechanische bzw. akustische Messmethoden in Frage; hinsichtlich der letzteren Verfahren ist zu bedenken, dass für die Messung der Schallgeschwindigkeit Übertragungsstrecken für Schallpulse mit einer gewissen Ausdehnung benötigt werden, wodurch die geforderte räumliche Auflösung der Messung beschränkt wird.

Mechanische Resonator-Sensoren beruhen auf der Tatsache, dass eine Änderung physikalischer Gasparameter (z.B. Temperatur, Druck, Art des jeweiligen Gases) infolge der Trägheit der bei einer Schwingung eines schwingungsfähigen mechanischen Bauelements (z.B. einer Schwingzunge) mitbewegten Gasmoleküle zu einer Verstimmung der Resonanzfrequenz des schwingenden Elements führt. Insbesondere ist bei konstanter Temperatur die Resonanzfrequenz des schwingenden Elements umso niedriger, je höher die Gasdichte ist.

Zur Bestimmung der Gasdichte wird die verstimmte Resonanzfrequenz bestimmt und mit einer (z.B. unverstimmten) Resonanzfrequenz bei bekannter Gasdichte (beispielsweise im Vakuum) verglichen. Anhand der bekannten Atom- bzw. Molekülmasse eines jeweils betrachteten Gases kann aus der Änderung der Resonanzfrequenz auf die Gasdichte des Gases geschlossen werden. Sind Temperatur und Druck konstant, kann analog aus der Verstimmung unter Berücksichtigung der Atom- bzw. Molekülmassen zweier bekannter Komponenten eines binären Gasgemisches dessen Zusammensetzung bestimmt werden.

Die Druckschrift US 2007/052970 A1 offenbart eine Sensorvorrichtung zum Detektieren von Eigenschaften eines Fluids, insbesondere Eigenschaften von Motoröl. Die Druckschrift US 2006/202592 A1 betrifft einen Piezomotor, der als u.a. Sensor verwendet werden kann.

Aus der US 2015/015118 A1 ist ein piezoelektrischer Resonator bekannt, und aus der Druckschrift US 2015/096385 A1 ein Verfahren und eine Vorrichtung zum Messen physikalischer Eigenschaften von Fluiden, die einen Gas- und einen Flüssigkeitsanteil aufweisen, mittels mindestens eines kryotauglichen, piezoelektrischen Oszillators.

Die Druckschrift DE 44 36 813 A1 offenbart eine Vorrichtung und eine Verfahren zur Bestimmung der Zusammensetzung von Gasmischungen. Die Vorrichtung umfasst einen mechanischen Resonator-Sensor; dieser weist dabei als schwingendes Element eine einseitig eingespannte Grundplatte auf, die mit einer Folie aus einem piezoelektrischen Material überzogen ist und so eine Aktuator-Seite (zur Anregung von Schwingungen des Elements) und eine Sensorseite (zu Erfassung der resultierenden Auslenkung) ausbildet. Die Druckschrift DE 91 00 101 U1 betrifft eine Vorrichtung zur Bestimmung von Gasart, Druck, Viskosität und Strömungsgeschwindigkeiten von Gasen.

Die bekannten Resonator-Sensoren sind allerdings für den Einsatz unter kryogenen Bedingungen nicht geeignet, weil sie den Belastungen beim Abkühlen nicht standhalten, so dass Brüche und/oder Risse auftreten. Zudem sind die Verformungen der verschiedenen Komponenten beim Abkühlen ungleichmäßig, weswegen es zu asymmetrischen Verformungen kommt, die Modensprünge in jeweils andere Resonanzschwingungsmoden zu Folge haben. Dies führt zu ungenauen Messungen.

Die vorliegende Erfindung hat die Aufgabe, eine Technik zur Erfassung einer Gasdichte und/oder einer Gaszusammensetzung bereitzustellen, die eine verbesserte Stabilität und Zuverlässigkeit bei Temperaturänderungen aufweist, insbesondere bei einer Abkühlung in kryogene Temperaturbereiche, und die daher für eine Anwendung im Bereich der Raumfahrt geeignet ist.

Die Aufgabe wird gelöst durch einen Resonator-Sensor gemäß Anspruch 1, einen Tank für einen Raketenantrieb gemäß Anspruch 8, eine Vorrichtung zur Bestimmung einer Gasdichte und/oder einer Gaszusammensetzung gemäß Anspruch 9, und ein Verfahren zur Bestimmung einer Gasdichte und/oder einer Gaszusammensetzung gemäß Anspruch 12. Vorteilhafte Ausführungsformen sind in den Unteransprüchen, der Beschreibung und den Figuren offenbart.

Ein erfindungsgemäßer Resonator-Sensor dient der Erfassung einer Gasdichte und/oder einer Gaszusammensetzung. Er umfasst eine Schwingzunge und eine Einspannvorrichtung zur Halterung der Schwingzunge. Auf mindestens einen Bereich einer Oberfläche der Schwingzunge ist mindestens ein Abschnitt einer Piezofolie aufgebracht. Die Einspannvorrichtung umfasst einen Einspannkörper mit einer Ausnehmung, in der ein Abschnitt der Schwingzunge eingesetzt und stoffschlüssig mit dem Einspannkörper verbunden (beispielsweise verklebt und/oder verschweißt) ist. Bei 20°C hat der Einspannkörper einen Elastizitätsmodul von mindestens 10 GPa und höchstens 50 GPa.

Ein derartiger Resonator-Sensor bietet den Vorteil, dass keine zusätzliche Komponenten, insbesondere keine metallische Schrauben und/oder Klemmen zur Befestigung der Schwingzunge an der Einspannvorrichtung erforderlich sind. Verformungen, die bei einem starken Abkühlen des Resonator-Sensors (beispielsweise in kryogene Temperaturbereiche unterhalb von -150°C) auftreten, können daher gleichmäßig erfolgen, was die Gefahr von Brüchen oder Rissen im Material reduziert. Zudem können Modensprünge mindestens weitgehend vermieden werden, was die Zuverlässigkeit der Messungen erhöht. Durch die stoffschlüssige Verbindung können ferner Vibrationen der Schwingzunge in der Ausnehmung verhindert werden, was die Haltbarkeit des Resonator-Sensors erhöht.

Die Schwingzunge kann beispielsweise ein biegsames, vorzugsweise flächiges Bauteil sein, das insbesondere in einem unbelasteten Zustand eben sein kann. Insbesondere kann die Schwingzunge als ein flexibles Plättchen ausgebildet sein.

Vorzugsweise weist die Schwingzunge eine Länge, eine Breite und eine Dicke auf, die paarweise orthogonal zueinander verlaufen; die Länge ist dabei vorteilhafterweise mindestens so groß wie die Breite, bevorzugterweise mindestens doppelt oder mindestens dreimal so groß ist wie die Breite. Die Breite ist vorzugsweise mindestens doppelt, bevorzugterweise mindestens dreimal oder mindestens sechsmal so groß wie die Dicke der Schwingzunge. Gemäß einer vorteilhaften Ausführungsform erstreckt sich mindestens eine im Wesentlichen glatte Oberfläche über die Länge und die Breite der Schwingzunge; der Oberflächenbereich, auf den der Abschnitt der Piezofolie aufgebracht ist, ist vorzugsweise ein Bereich einer derartigen Oberfläche.

Die Schwingzunge ist vorzugsweise in Richtung ihrer Länge in die Ausnehmung im Einspannkörper eingesteckt, der eingesteckte und in der Ausnehmung stoffschlüssig verbundene (z.B. verklebte und/oder verschweißte) Abschnitt kann bezüglich dieser Richtung (die hier auch als Längsrichtung der Schwingzunge bezeichnet wird) ein Ende der Schwingzunge sein; das andere Ende kann dabei vorzugsweise frei (also unbefestigt) in einen umgebenden Raum hineinragen.

Die Schwingzunge kann insbesondere mindestens teilweise aus Glas, Edelstahl, glasfaserverstärktem Kunststoff und/oder Silizium bestehen. Derartige Materialien sind haltbar und haben günstige Schwingeigenschaften.

Die Ausnehmung umfasst vorzugsweise mindestens eine Nut oder eine Kerbe im Einspannkörper, in welche die Schwingzunge hineingesteckt ist.

Gemäß der vorliegenden Erfindung weist die mindestens eine Piezofolie (zusätzlich zum auf dem Oberflächenbereich der Schwingzunge aufgebrachten Abschnitt) mindestens einen weiteren Abschnitt auf, in dem sie an der Einspannvorrichtung befestigt ist. Zwischen dem an der Schwingzunge aufgebrachten Abschnitt und dem weiteren, an der Einspannvorrichtung befestigten Abschnitt ist ein loser Abschnitt der Piezofolie angeordnet, in dem die Piezofolie flexibel ist, beispielsweise locker geschwungen.

Ein derartiger Abschnitt bietet eine Dehnungsreserve für die Piezofolie, die bei einer starken Temperaturänderung und der damit verbundenen Kontraktion bzw. Ausdehnung der Komponenten ein Reißen der Piezofolie verhindert.

Die mindestens eine Piezofolie kann mittels einer Klemmfeder in Kontaktverbindung mit mindestens einer Elektrode an der Einspannvorrichtung befestigt sein; mittels einer derartigen Elektrode kann der Resonator-Sensor an eine Messeinrichtung zur Bestimmung einer jeweils aktuellen Resonanzfrequenz der Schwingzunge des Resonator-Sensors angeschlossen oder anzuschließen sein, insbesondere an einen Schaltkreis oder eine Wechselspannungsquelle, über den bzw. die die Schwingzunge zur Schwingung angeregt werden kann. Die Klemmfeder, die vorzugsweise an einer von der Ausnehmung abgewandten Seite der Einspannvorrichtung angeordnet ist, kann insbesondere eine "Foldback-Klammer" (z.B. aus Federstahl mit elektrisch isolierter Oberfläche (z.B. Lack)) sein.

Eine derartige Befestigung mittels einer Klemmfeder ist nicht starr, sondern erlaubt Verschiebungen der eingeklemmten Elemente bei Kontraktionen und verhindert daher Materialbrüche oder -risse. Zudem erlaubt sie eine gleichmäßige Kraftverteilung, die zu einer Stabilisierung einer Schwingung auch bei Modenwechseln beiträgt.

Gemäß einer bevorzugten Ausführungsform besteht die mindestens eine Piezofolie mindestens teilweise aus einer metallbeschichteten Polyvinylidenfluorid-Folie (kurz: PVDF-Folie). Die Piezofolie kann mit einer (beispielswese aufgedampften) Metallschicht, z.B. einer Silber- und/oder Kupferschicht überzogen sein, die eine elektrische Leitfähigkeit gewährleistet.

Die mindestens eine Piezofolie kann (in dem genannten Abschnitt) auf der Schwingzunge aufgeklebt sein, beispielsweise mit flüssigem Kleber und/oder als Klebefolie, oder sie kann mindestens in dem Abschnitt mittels eines Beschichtungsverfahrens, beispielsweise eines Rotationsbeschichtungsverfahrens auf der Schwingzunge, mit ihrer Herstellung aufgebracht worden sein. Eine derart (ohne dazwischenliegende Klebeschicht) aufgebrachte Piezofolie ermöglicht eine auch bei großen Temperaturstürzen besonders robuste Verbindung zur Schwingzunge.

Vorzugsweise weist die mindestens eine Piezofolie eine Orientierung (also eine Reckrichtung, in die sich die Piezofolie bei Anlegen elektrischer Spannung dehnt) auf, die in Richtung einer Breite (orthogonal zu einer Richtung der Länge) der Schwingzunge verläuft. Eine derartige Orientierung begünstigt die Anregung einer gassensitiven 2/0-Mode. (Das Zahlenpaar gibt die Anzahl der Knotenlinien in x- bzw. y-Richtung bei der Schwingung einer Platte an: Bei einer Schwingung in 2/0 Mode gibt es somit zwei Knotenlinien parallel zur längeren Seite (also der Länge) und keine Knotenlinien parallel zur kürzeren Seite (also der Breite) des Resonators.) Zudem kann sie eine besonders hohe Schwingungsamplitude der Schwingzunge bewirken und damit - trotz eines schwächeren piezoelektrischen Effekts - eine gute Funktionalität auch im kryogenen Temperaturbereich (beispielsweise unterhalb -150°C) gewährleisten.

Gemäß einer bevorzugten Ausführungsform weist ein erfindungsgemäßer Resonator-Sensor (neben der genannten Piezofolie) eine zweite Piezofolie auf, von der ein Abschnitt auf einen zweiten Oberflächenbereich der Schwingzunge aufgebracht ist. Diese jeweiligen Oberflächenbereiche liegen einander dabei vorzugsweise gegenüber.

Eine dieser beiden Piezofolien kann dabei dazu eingerichtet sein, als Aktuator zur Anregung der Schwingzunge zu dienen (beispielsweise an einen Oszillator angeschlossen sein), und die andere der Piezofolien kann dazu eingerichtet sein, als Auslenkungssensor zu wirken (beispielsweise die Auslenkungen in Wechselspannungssignale umwandeln, die von einer vorzugsweise angeschlossenen Detektoreinrichtung erfasst werden können). Insbesondere kann ein derartiger Resonator-Sensor an eine Regelungsschaltung zur Einstellung bzw. Bestimmung einer jeweils aktuellen (vom umgebenden Gas abhängigen) Resonanzfrequenz angeschlossen oder anzuschließen sein; aus der aktuellen Resonanzfrequenz kann dann eine Gasdichte und/oder Gaszusammensetzung bestimmt werden.

Vorzugsweise haben die beiden Piezofolien gleiche, parallel zu einer Richtung des jeweiligen Oberflächenabschnitts der Schwingzunge verlaufende Orientierungen, also mögliche Dehnungsrichtungen. Besonders vorteilhaft ist eine Orientierung quer zur Längsrichtung der Schwingzunge. Insbesondere kann durch eine Kontraktion der Folien in dieser Richtung die vorteilhafte Anregung der 2/0 Mode begünstigt werden. Umgekehrt ist die Spannung auf der Detektor-Folie bei dieser Orientierung maximal, wenn der Resonator in der 2/0 Mode schwingt.

Der Einspannkörper besteht vorzugsweise mindestens teilweise aus einem nichtleitenden Material. Insbesondere kann der Einspannkörper ganz oder teilweise aus Kunststoff, Glas und/oder Keramik bestehen. Diese Materialien bewirken vorteilhaft geringe Dämpfungsverluste bei dem Resonator-Sensor.

Gemäß einer bevorzugten Ausführungsform besteht der Einspannkörper der Einspannvorrichtung mindestens teilweise aus einem faserverstärkten Kunststoff, z.B. aus einem glasfaserverstärkten Kunststoff. Insbesondere kann der Einspannkörper vorteilhaft eine Verstärkung aus einem Glasroving-Gewebe enthalten; ein derartiges Material weist einen relativ hohen Elastizitätsmodul (vorzugsweise 25 GPa oder höher) auf, so dass auftretende Dämpfungsverluste besonders gering sind.

Vorzugsweise ist der die Ausnehmung aufweisende Einspannkörper einteilig (monolithisch) geformt. Dadurch werden mögliche Beschädigungen durch Vibrationen vermieden.

Gemäß einer vorteilhaften Ausführungsvariante eines erfindungsgemäßen Resonator-Sensors hat der Einspannkörper der Einspannvorrichtung bei 20°C einen Elastizitätsmodul von mindestens 20 GPa, bevorzugter mindestens 25 GPa, noch bevorzugter mindestens 29 GPa . Alternativ oder zusätzlich kann der Einspannkörper bei 20°C einen durchschnittlichen thermischen Ausdehnungskoeffizienten von höchstens 25· 10⁻⁶ K⁻¹, bevorzugter höchstens 20 ·10⁻⁶ K⁻¹, haben.

Ein derartiges Einspannungsmaterial minimiert Dämpfungsverluste und weist eine entsprechend geringe Wärmedehnung auf. Verformungen, die bei Abkühlen insbesondere in kryogene Temperaturbereiche auftreten, können damit gleichmäßig gehalten und insbesondere Modensprünge weitgehend vermieden werden.

In einer vorteilhaften Ausführungsform weist eine Einspannvorrichtung eines erfindungsgemäßen Resonator-Sensors einen Temperatursensor, beispielsweise einen Dioden-Temperatursensor bzw. einen Widerstandstemperatursensor auf, der höchstens 1cm, bevorzugter höchstens 5mm, noch bevorzugter höchstens 3mm von der Schwingzunge beabstandet und/oder dazu eingerichtet ist, die Temperatur der Schwingzunge im Bereich der Ausnehmung zu messen. Damit lassen sich temperaturverursachte Resonanzfrequenz-Änderungen ermitteln und somit bei der Bestimmung einer Gasdichte bzw. Gaszusammensetzung berücksichtigen.

Ein erfindungsgemäßer Resonator-Sensor kann ein Gehäuse umfassen, das die Schwingzunge mindestens teilweise (gasdurchlässig) umgibt und sie vor einer Benetzung durch Flüssigkeitstropfen schützt, ohne die Schwingung zu beeinträchtigen. Dadurch können Fehlmessungen durch derartige Tropfen (die z.B. durch das Verspritzen von kryogenem Treibstoff entstanden sein können) verhindert werden.

Ein erfindungsgemäßer Tank für kryogenen Treibstoff (z.B. Flüssigwasserstoff, Flüssigsauerstoff oder Flüssigstickstoff) für einen Raketenantrieb weist einen Tankraum auf, in dem mindestens ein erfindungsgemäßer Resonator-Sensor gemäß einer der in dieser Schrift offenbarten Ausführungsformen angeordnet ist.

Dadurch wird eine Überwachung des Tanks auf seinen Tankinhalt hin möglich; insbesondere kann eine lokale Schutzgaskonzentration bestimmt werden.

Der Resonator-Sensor des Tanks kann Teil einer erfindungsgemäßen Vorrichtung gemäß einer der in dieser Schrift offenbarten Ausführungsformen sein. Vom Resonator-Sensor verschiedene Komponenten (z.B. eine Messeinrichtung zur Bestimmung einer jeweils aktuellen Resonanzfrequenz und/oder eine Auswertungskomponente zur Bestimmung der Gasdichte bzw. Gaszusammensetzung) einer derartigen Vorrichtung können dabei außerhalb des Tankraums angeordnet sein.

Eine erfindungsgemäße Vorrichtung zur Bestimmung einer Gasdichte und/oder einer Gaszusammensetzung umfasst einen Resonator-Sensor gemäß einer in dieser Schrift offenbarten Ausführungsform, ferner eine Messeinrichtung zur Bestimmung einer jeweils aktuellen Resonanzfrequenz der Schwingzunge des Resonator-Sensors und eine Auswertungskomponente zur Bestimmung der Gasdichte bzw. Gaszusammensetzung auf Grundlage der aktuellen (nämlich jeweils von der Messeinrichtung bestimmten) Resonanzfrequenz. Vorzugsweise umfasst die Auswertungskomponente zudem eine Anzeigeeinrichtung, mit der die bestimmte Gasdichte bzw. Gaszusammensetzung einem Verwender der Vorrichtung angezeigt werden kann.

Bei einer vorteilhaften Ausführungsform einer erfindungsgemäßen Vorrichtung umfasst die Messeinrichtung eine Regelungsschaltung zur Einstellung einer Schwingung der Schwingzunge in der aktuellen (von der die Schwingzunge umgebenden Gasdichte bzw. Gaszusammensetzung abhängigen) Resonanzfrequenz der Schwingzunge. Die Regelungsschaltung weist dabei vorzugsweise einen Oszillator zur Anregung der Schwingzunge (mittels der als Aktuator wirkenden Piezofolie) und eine Detektoreinrichtung zum Erfassen einer resultierenden Schwingung (beispielsweise in Form von Wechselspannungssignalen, die von einer als Auslenkungssensor dienenden Piezofolie des Resonator-Sensors geliefert werden) auf (so dass also der Oszillator in Abhängigkeit von durch die Detektoreinrichtung erfassten Werte gesteuert wird).

Eine derartige Detektoreinrichtung umfasst vorzugsweise eine Ladungsverstärkerschaltung; so kann die Genauigkeit der Vorrichtung erhöht werden, weil auch schwache Signale (wie sie insbesondere in kryogenen Temperaturbereichen auftreten können) eindeutig detektiert werden können.

Der Oszillator kann dazu eingerichtet sein, die Schwingzunge mit einem Chirp-Signal anzuregen, das vorzugsweise den Frequenzbereich, der durch Temperaturänderungen überstrichen wird, (beispielsweise 6 kHz bis 10 kHZ) enthält. Die Messeinrichtung kann dann vorteilhafterweise dazu eingerichtet sein, aus der FourierTransformierten eines Antwort-Signals des Resonator-Sensors die Resonanzfrequenz zu ermitteln. Alternativ oder zusätzlich kann die Messeinrichtung dazu eingerichtet sein, die Resonanzfrequenz aus der komplexen Impedanz des Schwingkreises, der aus einer mit der Schwingzunge kraftschlüssig verbundenen Piezofolie und einer Wechselspannungsquelle besteht, zu bestimmen. Eine derartige Ausführungsform hat insbesondere den Vorteil, dass der Resonator-Sensor dabei nur eine einzige Piezofolie zu haben braucht (die dann als Aktuator dient). Schließlich kann die Messeinrichtung zur Erfassung einer Resonanzfrequenz (alternativ oder zusätzlich) eine phasengesperrte Regelschleife (PLL) umfassen, die eine Echtzeit-Verfolgung der Phasenlage ermöglicht.

Ein erfindungsgemäßes Verfahren dient der Bestimmung einer Gasdichte oder einer Gaszusammensetzung. Es umfasst ein Bestimmen einer aktuellen (nämlich von einer jeweiligen Gasumgebung abhängigen) Resonanzfrequenz einer Schwingzunge eines Resonator-Sensors; ein Abschnitt der Schwingzunge ist dabei in einer Ausnehmung eines Einspannkörpers einer Einspannvorrichtung des Resonator-Sensors eingesetzt und mit der Einspannvorrichtung stoffschlüssig verbunden. Bei 20°C hat der Einspannkörper einen Elastizitätsmodul von mindestens 10 GPa und höchstens 50 GPa. Das Verfahren umfasst zudem ein Berechnen der Gasdichte bzw. der Gaszusammensetzung auf Grundlage der bestimmten aktuellen Resonanzfrequenz.

Der in einem erfindungsgemäßen Verfahren eingesetzte Resonator-Sensor ist vorzugsweise gemäß einer der in dieser Schrift offenbarten Ausführungsformen ausgebildet.

Das Verfahren kann insbesondere ein Anregen der Schwingzunge des Resonator-Sensors in dem Tank einer Rakete und/oder bei Kryotemperatur umfassen, beispielsweise unterhalb von -150°C, vorzugsweise unterhalb -170°C oder sogar unterhalb - 250°C, umfassen.

Gemäß einer vorteilhaften Ausführungsform umfasst das Verfahren ein Bestimmen einer jeweils aktuellen Resonanzfrequenz nacheinander bei verschiedenen Temperaturen, beispielsweise bei einer Temperatur unterhalb von -150°C (oder sogar unterhalb von -250°C) und bei einer Temperatur in einem Bereich von -50°C bis 0°C.

Vorteilhaft ist eine Ausführungsform, bei der das Verfahren eine Gasdichte bzw. Gaszusammensetzung eines binären Helium-Wasserstoffgemischs, eines binären Helium-Stickstoffgemischs oder eines binären Helium-Sauerstoffgemischs bestimmt.

Im Folgenden werden bevorzugte Ausführungsbeispiele der Erfindung anhand von Zeichnungen näher erläutert. Es versteht sich, dass einzelne Elemente und Komponenten auch anders kombiniert werden können als dargestellt. Bezugszeichen für einander entsprechende Elemente sind figurenübergreifend verwendet und werden ggf. nicht für jede Figur neu beschrieben.

Es zeigen schematisch:
- Figur 1:: eine exemplarische Vorrichtung zur Bestimmung einer Gasdichte und/oder einer Gaszusammensetzung mit einem im Längsschnitt (in Längsrichtung der Schwingzunge) dargestellten Resonator-Sensor gemäß einer Ausführungsform der vorliegenden Erfindung;
- Figur 2a:: eine schematische Draufsicht auf eine eingespannte Schwingzunge mit aufgebrachter Piezofolie; und
- Figur 2b:: eine Abfolge von Querschnitten durch eine schwingende Schwingzunge.

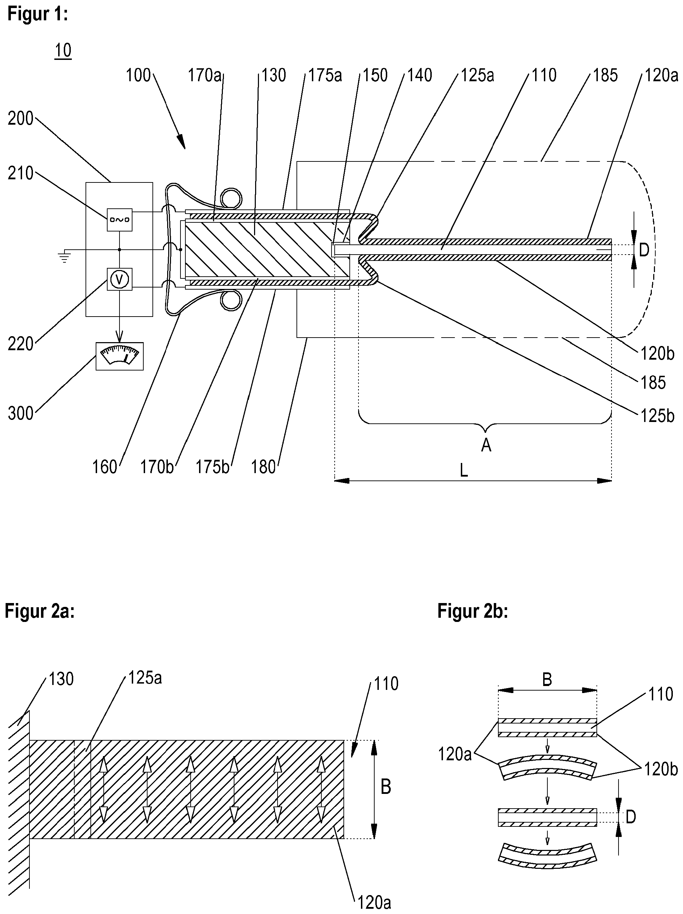

In Figur 1 ist eine Vorrichtung 10 zur Bestimmung einer Gasdichte und/oder einer Gaszusammensetzung gemäß einer Ausführungsform der vorliegenden Erfindung vereinfacht und nicht maßstabsgetreu dargestellt.

Die Vorrichtung 10 umfasst einen Resonator-Sensor 100 mit einer Schwingzunge 110, die in eine Ausnehmung 140 eines Einspannkörpers 130 einer Einspannvorrichtung eingesetzt und mittels eines Klebstoffs 150 stoffschlüssig mit dem Einspannkörper verbunden ist. Erfindungsgemäß hat der Einspannkörper (der z.B. ganz oder teilweise aus Kunststoff, Glas und/oder Keramik bestehen kann) bei 20°C einen Elastizitätsmodul von mindestens 10 GPa und höchstens 50 GPa. In der Figur 1 ist der Resonator-Sensor in einem Längsschnitt der Schwingzunge dargestellt; die Länge L der Schwingzunge verläuft dabei in der Darstellung der Figur 1 horizontal, ihre Dicke D vertikal.

In einem Bereich A der Schwingzunge 110 ist auf den einander gegenüberliegenden Oberflächen der Schwingzunge jeweils ein Abschnitt einer Piezofolie 120a bzw. 120b aufgebracht, beispielsweise aufgeklebt.

Beide Piezofolien 120a, 120b sind (in einem jeweiligen weiteren Abschnitt) an der Einspannvorrichtung befestigt, und zwar jeweils in Kontaktverbindung mit je zwei Elektroden 170a, 175a bzw. 170a, 170b. Je eine Elektrode 170a, 170b ist dabei zwischen Einspannkörper 130 und Piezofolie angeordnet und mit Masse verbunden. Je eine weitere Elektrode 175a, 175b ist auf der gegenüberliegenden, äußeren Seite der Piezofolie angeordnet. Eine Klemmfeder 160 dient dazu, einen zuverlässigen Kontakt auch bei Temperaturen im Kryobereich sicherzustellen.

Die Elektroden 175a, 175b sind an eine Messeinrichtung 200 zur Bestimmung einer jeweils aktuellen (von dem die Schwingzunge umgebenden Gas abhängigen) Resonanzfrequenz der Schwingzunge angeschlossen. Die Messeinrichtung umfasst eine Regelungsschaltung mit einem Oszillator 210 und einer Detektoreinrichtung 220 (hier symbolisch mit einem Spannungsmesser dargestellt). Mittels des Oszillators 210 (über eine jeweils angelegten Wechselspannung) und die an ihn angeschlossene, damit als Aktuator wirkende Piezofolie 120a kann eine Schwingung der Schwingzunge 110 angeregt werden, deren Auslenkung über die an die Detektoreinrichtung 220 angeschlossene und dann als Auslenkungssensor dienende Piezofolie 120b erfasst werden kann. So kann eine jeweils aktuelle Resonanzfrequenz der Schwingzunge experimentell eingeregelt und bestimmt werden.

Die so bestimmte Resonanzfrequenz kann (unter Berücksichtigung einer jeweiligen Temperatur und des Gasdrucks) mittels einer Auswertungskomponente 300 der Vorrichtung 10 in eine jeweilige Gasdichte bzw. (bei konstanter Temperatur und konstantem Druck) Gaszusammensetzung umgerechnet und vorzugsweise mit einer Anzeige angezeigt werden. Zur Bestimmung der jeweiligen Temperatur kann die Einspannvorrichtung einen (in der Figur 1 nicht gezeigten) Temperatursensor, beispielsweise Dioden-Temperatursensor bzw. Widerstandstemperatursensor aufweisen, der vorzugsweise nicht weiter als 1cm, bevorzugter nicht weiter als 5mm, noch bevorzugter höchstens 3mm von der Schwingzunge beabstandet ist und/oder der dazu eingerichtet ist, die Temperatur im Bereich der Ausnehmung (bzw. an einem Fußpunkt der Schwingzunge) zu messen und an die Auswertungseinheit zu übermitteln.

Zwischen dem an der Schwingzunge aufgebrachten Abschnitt und dem weiteren, an der Einspannvorrichtung befestigten Abschnitt weist jede der Piezofolien 120a, 120b einen losen Abschnitt 125a bzw. 125b auf, in dem die jeweilige Piezofolie locker geschwungen ist. Diese Abschnitte 125a, 125b bilden eine Dehnungsreserve für die Piezofolien und verhindern auch bei starken Temperaturänderungen und daraus resultierenden Kontraktionen des Resonator-Sensors eine Beschädigung, insbesondere ein Reißen der Piezofolien.

Der in der Figur 1 gezeigte Resonator-Sensor weist zudem ein Gehäuse 180 auf, das die Schwingzunge umgibt und sie vor einer Benetzung durch Flüssigkeitstropfen schützt, ohne die Schwingung zu beeinträchtigen. Durch Öffnungen 185 in dem Gehäuse kann das jeweils zu analysierende Gas in das Gehäuse eindringen und so die Resonanzfrequenz der Schwingzunge beeinflussen.

In Figur 2a ist in vereinfachter Darstellung eine Draufsicht auf die in den Einspannkörper 130 einer Einspannvorrichtung eingesetzte Schwingzunge 110 eines exemplarischen erfindungsgemäßen Resonator-Sensors gezeigt. Auf die in der Figur sichtbare Oberfläche der Schwingzunge ist eine Piezofolie 120a aufgebracht. Wie durch die Pfeile angegeben, weist die Piezofolie eine Orientierung in Richtung der Breite B der Schwingzunge auf, so dass sie also bei Anlegen von Spannung ihre Breite vergrößern und sich wieder zusammenziehen kann. Dadurch kann eine in Figur 2b dargestellte Schwingung angeregt werden.

Die der Piezofolie 120a gegenüber auf die Schwingzunge aufgebrachte Piezofolie 120b (die in der Figur 2a nicht sichtbar ist) ist vorzugsweise dazu eingerichtet, die Schwingung in Wechselstromsignale umzuwandeln, die mit einer entsprechenden Detektoreinrichtung erfasst werden können; so kann die Piezofolie 120b als Auslenkungssensor fungieren.

Zudem könnte die Anordnung der Piezofolien auch umgekehrt zur in der Figur 2b gezeigten Variante sein, bei der die als Aktuator wirkende Piezofolie 120a oben und die als Auslenkungssensor dienende Piezofolie 120b unten liegt.

Gemäß einer zur in den Figuren 2a, 2b alternativen Ausführungsform verläuft die Orientierung der als Aktuator wirkenden Piezofolie in Längsrichtung der Schwingzunge, so dass diese sich bei einer Schwingung längs krümmen kann.

Wie oben erwähnt, kann eine Schwingzunge einer anderen (nicht gezeigten) Ausführungsform eines erfindungsgemäßen Resonator-Sensors auch lediglich eine einzige Piezofolie umfassen; die Resonanzfrequenz kann dabei über die komplexe Impedanz einer von der Messeinrichtung umfassten Regelungsschaltung bestimmt werden.

Ein erfindungsgemäßer Resonator-Sensor 100 dient einer Erfassung einer Gasdichte und/oder einer Gaszusammensetzung insbesondere in einem kryogenen Temperaturbereich. Er umfasst eine Schwingzunge 110 mit mindestens einer in einem Abschnitt darauf aufgebrachten Piezofolie 120a, 120b sowie eine Einspannvorrichtung zur Halterung der Schwingzunge. Die Einspannvorrichtung umfasst einen Einspannkörper 130 mit einer Ausnehmung 140, in der ein Abschnitt der Schwingzunge eingesetzt und stoffschlüssig mit dem Einspannkörper verbunden ist. Bei 20°C hat der Einspannkörper 130 einen Elastizitätsmodul von mindestens 10 GPa und höchstens 50 GPa. Ein erfindungsgemäßer Tank und eine erfindungsgemäße Vorrichtung 10 umfassen einen erfindungsgemäßen Resonator-Sensor 100. Ein erfindungsgemäßes Verfahren dient einer Bestimmung einer Gasdichte oder einer Gaszusammensetzung und kann insbesondere in einem kryogenen Temperaturbereich angewandt werden.

### Bezugszeichen

- 10: Vorrichtung

- 100: Resonator-Sensor
- 110: Schwingzunge
- 120a, 120b: Piezofolie
- 125a, 125b: loser Abschnitt
- 130: Einspannkörper
- 140: Ausnehmung
- 150: Klebstoff
- 160: Klemme
- 170a, 170b, 175a, 175b: Elektrode
- 180: Gehäuse
- 185: Öffnung

- 200: Messeinrichtung
- 210: Oszillator
- 220: Detektoreinrichtung

- 300: Auswertungskomponente

- A: Bereich der Schwingzunge
- B: Breite der Schwingzunge
- D: Dicke der Schwingzunge
- L: Länge der Schwingzunge

## Patentansprüche

1. Resonator-Sensor (100) zur Erfassung einer Gasdichte und/oder einer Gaszusammensetzung, der eine Schwingzunge (110), mindestens eine Piezofolie (120a, 120b) und eine Einspannvorrichtung zur Halterung der Schwingzunge aufweist,
wobei auf mindestens einen Oberflächenbereich (A) der Schwingzunge mindestens ein Abschnitt der mindestens einen Piezofolie aufgebracht ist,
und wobei die Einspannvorrichtung einen Einspannkörper (130) mit einer Ausnehmung (140) umfasst, in der ein Abschnitt der Schwingzunge (110) eingesetzt und stoffschlüssig mit dem Einspannkörper verbunden ist, wobei der Einspannkörper (130) bei 20°C einen Elastizitätsmodul von mindestens 10 GPa und höchstens 50 GPa hat,
wobei die mindestens eine Piezofolie (120a, 120b) mindestens einen weiteren Abschnitt aufweist, in dem sie an der Einspannvorrichtung befestigt ist, und wobei die Piezofolie zwischen dem an der Schwingzunge aufgebrachten Abschnitt und dem weiteren, an der Einspannvorrichtung befestigten Abschnitt einen losen Abschnitt (125a, 125) aufweist, in dem sie flexibel ist.

2. Resonator-Sensor gemäß Anspruch 1, wobei die mindestens eine Piezofolie mittels einer Klemmfeder (160) in Kontaktverbindung mit mindestens einer Elektrode (170a, 170b, 175a, 175b) an der Einspannvorrichtung befestigt ist

3. Resonator-Sensor gemäß einem der Ansprüche 1 oder 2, wobei der Einspannkörper (130) ganz oder teilweise aus Kunststoff, Glas und/oder Keramik besteht.

4. Resonator-Sensor gemäß einem der vorhergehenden Ansprüche, der zwei Piezofolien (120a, 120b) umfasst, von denen jeweils ein Abschnitt auf einander gegenüberliegende Oberflächenbereiche der Schwingzunge aufgebracht ist,
wobei die mindestens zwei Piezofolien vorzugsweise gleiche Orientierungen aufweisen.

5. Resonator-Sensor gemäß einem der vorhergehenden Ansprüche, wobei der Einspannkörper (130) bei 20°C einen Elastizitätsmodul von mindestens 20 GPa, bevorzugter mindestens 25 GPa, noch bevorzugter mindestens 29 GPa hat
und/oder wobei der Einspannkörper (130) bei 20°C einen durchschnittlichen thermischen Ausdehnungskoeffizienten von höchstens 25· 10⁻⁶ K⁻¹, bevorzugter höchstens 20 ·10⁻⁶ K¹ hat.

6. Resonator-Sensor gemäß einem der vorhergehenden Ansprüche, wobei die Einspannvorrichtung einen Temperatursensor, insbesondere einen Dioden-Temperatursensor bzw. Widerstandstemperatursensor aufweist, der höchstens 1cm, bevorzugter höchstens 5mm, noch bevorzugter höchstens 3mm von der Schwingzunge (110) beabstandet und/oder dazu eingerichtet ist, die Temperatur der Schwingzunge (110) im Bereich der Ausnehmung (140) zu messen.

7. Resonator-Sensor gemäß einem der vorhergehenden Ansprüche, wobei die Schwingzunge (110) mindestens teilweise durch ein Gehäuse (180) vor einer Benetzung durch Flüssigkeitstropfen geschützt ist.

8. Tank für kryogenen Treibstoff für einen Raketenantrieb, wobei der Tank einen Tankraum aufweist, in dem ein Resonator-Sensor (100) gemäß einem der vorhergehenden Ansprüche angeordnet ist.

9. Vorrichtung (10) zur Bestimmung einer Gasdichte und/oder einer Gaszusammensetzung, wobei die Vorrichtung umfasst:
- einen Resonator-Sensor (100) gemäß einem der vorhergehenden Ansprüche;
- eine Messeinrichtung (200) zur Bestimmung einer jeweils aktuellen Resonanzfrequenz der Schwingzunge (110) des Resonator-Sensors; und
- eine Auswertungskomponente (300) zur Bestimmung der Gasdichte bzw. Gaszusammensetzung auf Grundlage der aktuellen Resonanzfrequenz.

10. Vorrichtung gemäß Anspruch 9, wobei die Messeinrichtung eine Regelungsschaltung zur Einstellung einer Schwingung der Schwingzunge in der aktuellen Resonanzfrequenz der Schwingzunge aufweist,
wobei die Regelungsschaltung einen Oszillator (210) zur Anregung der Schwingzunge (110) und eine Detektoreinrichtung (220) zum Erfassen einer resultierenden Schwingung umfasst.

11. Vorrichtung gemäß Anspruch 9 oder 10, wobei die Vorrichtung zudem einen elektrischen Resonanzkreis umfasst, der mit dem Resonator-Sensor (100) gekoppelt ist,
und wobei die Messeinrichtung dazu eingerichtet ist, eine aktuelle Güte des Resonanzkreises zu messen und daraus die aktuelle Resonanzfrequenz zu bestimmen.

12. Verfahren zur Bestimmung einer Gasdichte oder einer Gaszusammensetzung, das umfasst:
- ein Bestimmen einer aktuellen Resonanzfrequenz einer Schwingzunge (110) eines Resonator-Sensors (100) gemäß einem der Ansprüche 1 bis 7; und
- ein Berechnen der Gasdichte bzw. Gaszusammensetzung auf Grundlage der bestimmten aktuellen Resonanzfrequenz.

13. Verfahren gemäß Anspruch 12, das ein Anregen der Schwingzunge (110) des Resonator-Sensors (100) bei Kryotemperatur umfasst, wobei eine Kompensation eines Temperatureinflusses auf die Resonanzfrequenz mit Hilfe eines Temperatursensors gemäß Anspruch 7 erfolgt.

14. Verfahren gemäß einem der Ansprüche 12 oder 13, wobei die Gaszusammensetzung eines binären Helium-Wasserstoffgemisch, eines binären Helium-Sauerstoffgemisch oder eines binären Helium-Stickstoffgemisch bestimmt wird.

## Claims

1. Resonator sensor (100) for detecting a gas density and/or a gas composition, which has an oscillating tongue (110), at least one piezo film (120a, 120b), and a clamping device for holding the oscillating tongue, wherein at least one section of the at least one piezo film is applied to at least one surface area (A) of the oscillating tongue, and wherein the clamping device comprises a clamping body (130) with a recess (140) in which a section of the oscillating tongue (110) is inserted and is materially connected to the clamping body, wherein the clamping body (130) has a modulus of elasticity of at least 10 GPa and at most 50 GPa at 20°C, wherein the at least one piezo film (120a, 120b) has at least one further section in which it is fixed on the clamping device, and wherein the piezo film has a loose section (125a, 125), in which it is flexible, between the section applied to the oscillating tongue and the further section fixed to the clamping device.

2. Resonator sensor according to claim 1, wherein the at least one piezo film is fixed on the clamping device by means of a clamping spring (160) in contact connection with at least one electrode (170a, 170b, 175a, 175b).

3. Resonator sensor according to one of claims 1 or 2, wherein the clamping body (130) consists wholly or partially of plastic, glass, and/or ceramic.

4. Resonator sensor according to one of the preceding claims, which comprises two piezo films (120a, 120b), one section of each being respectively applied to opposite surface areas of the oscillating tongue, wherein the at least two piezo films preferably have the same orientation.

5. Resonator sensor according to one of the preceding claims, wherein the clamping body (130) has a modulus of elasticity of at least 20 GPa, preferably at least 25 GPa, more preferably at least 29 GPa at 20°C, and/or wherein the clamping body (130) has an average thermal coefficient of expansion of at most 25*10⁻⁶ K⁻¹, preferably at most 20*10⁻⁶ K⁻¹ at 20°C.

6. Resonator sensor according to one of the preceding claims, wherein the clamping device has a temperature sensor, in particular a diode temperature sensor or a resistance temperature sensor, which is spaced apart at most 1 cm, preferably at most 5 mm, more preferably at most 3 mm from the oscillating tongue (110), and/or is equipped to measure the temperature of the oscillating tongue (110) in the area of the recess (140).

7. Resonator sensor according to one of the preceding claims, wherein the oscillating tongue (110) is protected at least partially by a housing (180) from wetting by liquid droplets.

8. Tank for cryogenic fuel for a rocket engine, wherein the tank has a tank space in which a resonator sensor (100) according to one of the preceding claims is arranged.

9. Device (10) for determining a gas density and/or a gas composition, wherein the device comprises:
- a resonator sensor (100) according to one of the preceding claims;
- a measuring device (200) to determine a respective current resonance frequency of the oscillating tongue (110) of the resonator sensor; and
- an evaluation component (300) for determining a gas density and/or a gas composition on the basis of the current resonance frequency.

10. Device according to claim 9, wherein the measuring device has a control circuit for adjusting an oscillation of the oscillating tongue in the current resonance frequency of the oscillating tongue, wherein the control circuit comprises an oscillator (210) for exciting the oscillating tongue (110) and a detector device (220) for detecting a resulting oscillation.

11. Device according to claim 9 or 10, wherein the device additionally comprises an electrical resonance circuit, which is coupled to the resonator sensor (100), and wherein the measuring device is equipped to measure a current quality of the resonance circuit and to determine the current resonance frequency therefrom.

12. Method for determining a gas density and/or a gas composition, which comprises:
- determination of a current resonance frequency of an oscillating tongue (110) of a resonator sensor (100) according to one of claims 1 to 7; and
- calculation of the gas density or gas composition on the basis of the determined current resonance frequency.

13. Method according to claim 12, which comprises the excitation of the oscillating tongue (110) of the resonator sensor (100) at the cryogenic temperature, wherein a compensation of a temperature influence on the resonance frequency is carried out with the aid of a temperature sensor according to claim 7.

14. Method according to one of claims 12 or 13, wherein the gas composition is determined for a binary helium-hydrogen mixture, a binary helium-oxygen mixture, or a binary helium-nitrogen mixture.

## Revendications

1. Capteur à résonateur (100) pour la saisie d'une densité de gaz et/ou d'une composition gazeuse, qui comporte une languette oscillante (110), au moins une feuille piézoélectrique (120a, 120b) et un dispositif de serrage pour le maintien de la languette oscillante, sachant que sur au moins une zone de surface (A) de la languette oscillante est placée au moins une section d'au moins une feuille piézoélectrique, et sachant que le dispositif de serrage comprend un corps de serrage (130) avec un évidement (140) dans lequel une section de la languette oscillante (110) est insérée et reliée par conformité de matière au corps de serrage, sachant que le corps de serrage (130) a, à 20°C, un module d'élasticité d'au moins 10 GPa et au maximum de 50 GPa, sachant qu'au moins une feuille piézoélectrique (120a, 120b) comporte au moins une autre section dans laquelle elle est fixée au dispositif de serrage et sachant que la feuille piézoélectrique comporte entre la section placée sur la languette oscillante et l'autre section fixée au dispositif de serrage, une section libre (125a, 125) dans laquelle elle est flexible.

2. Capteur à résonateur selon la revendication 1, sachant qu'au moins une feuille piézoélectrique est fixée au dispositif de serrage au moyen d'un ressort de serrage (160) en liaison par contact avec au moins une électrode (170a, 170b, 175a, 175b).

3. Capteur à résonateur selon l'une quelconque des revendications 1 ou 2, sachant que le corps de serrage (130) est composé entièrement ou en partie de matière plastique, de verre et/ou de céramique.

4. Capteur à résonateur selon l'une quelconque des revendications précédentes, qui comprend deux feuilles piézoélectriques (120a, 120b), dont une section est respectivement placée sur les zones de surface opposées l'une à l'autre de la languette oscillante, sachant qu'au moins deux feuilles piézoélectriques comportent de préférence les mêmes orientations.

5. Capteur à résonateur selon l'une quelconque des revendications précédentes, sachant que le corps de serrage (130) a, à 20°C, un module d'élasticité d'au moins 20 GPa, de préférence d'au moins 25 GPa, de préférence encore d'au moins 29 GPa, et/ou sachant que le corps de serrage (130) a, à 20°C, un coefficient de dilatation thermique moyen d'un maximum de 25. 10⁻⁶K⁻¹, de préférence d'un maximum de 20. 10⁻⁶K⁻¹.

6. Capteur à résonateur selon l'une quelconque des revendications précédentes, sachant que le dispositif de serrage comporte un capteur de température, en particulier un capteur de température à diodes ou un capteur de température à résistance, qui est éloigné au maximum de 1 cm, de préférence au maximum de 5 mm, de préférence encore au maximum de 3 mm de la languette oscillante (110) et/ou est agencé pour mesurer la température de la languette oscillante (110) dans la zone de l'évidement (140).

7. Capteur à résonateur selon l'une quelconque des revendications précédentes, sachant que la languette oscillante (110) est protégée au moins en partie par un boîtier (180) contre une humectation par des gouttes de liquide.

8. Réservoir pour carburant cryogénique pour une propulsion de fusée, sachant que le réservoir comporte un compartiment de réservoir dans lequel est disposé un capteur à résonateur (100) selon l'une quelconque des revendications précédentes.

9. Dispositif (10) de détermination d'une densité de gaz et/ou d'une composition gazeuse, sachant que le dispositif comprend :
- un capteur à résonateur (100) selon l'une quelconque des revendications précédentes,
- un dispositif de mesure (200) pour déterminer une fréquence de résonance respectivement actuelle de la languette oscillante (110) du capteur à résonateur, et
- un composant d'évaluation (300) pour déterminer la densité de gaz ou la composition gazeuse sur la base de la fréquence de résonance actuelle.

10. Dispositif selon la revendication 9, sachant que le dispositif de mesure comporte un circuit de régulation pour régler une oscillation de la languette oscillante dans la fréquence de résonance actuelle de la languette oscillante, sachant que le circuit de régulation comprend un oscillateur (210) pour stimuler la languette oscillante (110) et un dispositif de détection (220) pour saisir une oscillation résultante.

11. Dispositif selon la revendication 9 ou 10, sachant que le dispositif comprend en outre un circuit de résonance électrique, qui est couplé au capteur à résonateur (100), et sachant que le système de mesure est agencé pour mesurer une qualité actuelle du circuit de résonance et déterminer à partir de cela la fréquence de résonance actuelle.

12. Procédé de détermination d'une densité de gaz ou d'une composition gazeuse, qui comprend :
- une détermination d'une fréquence de résonance actuelle d'une languette oscillante (110) d'un capteur à résonateur (100) selon l'une quelconque des revendications 1 à 7, et
- un calcul de la densité de gaz ou de la composition gazeuse sur la base de la fréquence de résonance actuelle déterminée.

13. Procédé selon la revendication 12, qui comprend une stimulation de la languette oscillante (110) du capteur à résonateur (100) à une cryotempérature, sachant qu'une compensation d'un effet de température sur la fréquence de résonance a lieu à l'aide d'un capteur de température selon la revendication 7.

14. Procédé selon l'une quelconque des revendications 12 ou 13, sachant que la composition gazeuse d'un mélange hélium-eau binaire, d'un mélange hélium-oxygène binaire ou d'un mélange hélium-azote binaire est déterminée.
